# EUROPEAN PATENT APPLICATION

(11) **EP 4 266 379 A1**
(43) Date of publication of application: **25.10.2023**
(21) Application number: 22168975.5
(22) Date of filing: 20.04.2022
(51) Int. Cl.: H01L 31/05, H01L 31/02, H01L 31/048, H02S 20/00, H02S 30/10

(54) **PHOTOVOLTAIC PANEL SUCH AS A PV INTEGRATED VEHICLE BODY PANEL AND METHOD FOR PRODUCING SAME USING E.G. A ROLL-TO-ROLL PROCEDURE**

(71) Applicant: Sono Motors GmbH, 80935 München (DE)
(72) Inventor: BAUDRIT, Mathieu, 80636 München (DE); ARROMBA, Iara, 80935 München (DE)
(74) Representative: Qip Patentanwälte Dr. Kuehn & Partner mbB

(57) **Abstract**

A method for producing a photovoltaic (PV) panel (1), particularly a PV vehicle body panel serving e.g. as a lining for a cargo box of a truck or a trailer is described. The method comprises providing a sheet-like PV label (3) in a roll configuration (29), providing a support structure (5) having a higher rigidity than the PV label, unrolling the PV label from the roll configuration, and fixing the PV label to the support structure. The PV label comprises a front stabilisation foil (13), a front lamination foil (15), a rear lamination foil (17) and, optionally, a rear stabilisation foil (19) as well as a solar cell arrangement (21) interposed between the front and rear lamination foils. The solar cell arrangement comprises multiple solar cell strings (25) arranged next to each other along a length direction (31). Each solar cell string comprises multiple solar cells (23) being arranged next to each other along a width direction (33) and being electrically interconnected. The photovoltaic label further comprises multiple electrically conductive switchback lines (27). For each of the solar cell strings, at least at a first side edge (35) of the photovoltaic label, an electrical connection line (39) being interconnected to a first end of the solar cell string is remotely accessible. For each of the solar cell strings, an associated one of the switchback lines extends from an area at or close to a second side edge (37) of the photovoltaic label to the first side edge of the photovoltaic label and a portion of the switchback line is remotely accessible at the first side edge of the photovoltaic label. The solar cell strings of the PV panel may be electrically interconnected in an a-posteriori interconnecting procedure, thereby allowing providing the PV panel with an individually adjusted length (1).

## Description

### FIELD OF THE INVENTION

The present invention relates to a method for producing a photovoltaic panel, particularly for producing a photovoltaic vehicle body panel, into which a solar cell arrangement is integrated. Furthermore, the present invention relates to the photovoltaic panel, particularly to the photovoltaic vehicle body panel which may optionally be produced with the method described herein.

### TECHNICAL BACKGROUND

In the following, the term "photovoltaic" may be abbreviated by "PV". PV cells may also be referred to as solar cells.

Furthermore, while the term "vehicle body panel" may refer to a panel which may be included in and/or attached to a body of any kind of vehicles such as cars, trucks, busses, mobile homes, trains, ships, airplanes, etc., embodiments are described herein with reference to body panels forming a cargo box of a truck, for simplicity of description.

Conventionally, most commercially available PV panels are typically produced by providing planar, rigid, wafer-based solar cells and then laminating these solar cells between a front side glass sheet and a rear side support structure such as another glass sheet or a metal sheet. Therein, the solar cells are interposed between thin lamination foils serving for both, tightly encapsulating the solar cells and mechanically interconnecting the stack including the front and rear side sheets with the interposed solar cell arrangement. All solar cells to be comprised in the PV panel are generally electrically interconnected with each other before being interposed and laminated with the lamination foils, such that an electrical connection to the solar cells comprised in the final PV panel may be established via a single junction box (or in some cases very few junction boxes, typically less than four junction boxes). Such PV panels are also referred to as PV modules and have typically a planar structure with the predefined standard size. These PV panels are well suited for installation on buildings or in solar farms.

Approaches have been presented in which PV cells are provided at a body of a vehicle for generating electricity to be supplied to the vehicle. Such electricity may be used for example for charging batteries of an electric car or for supplying electrical energy to power consuming assemblies such as for example a refrigeration unit.

For example, it has been proposed e.g. in an earlier patent application WO 2019/020718 A1 of the present applicant to provide solar cells in a body panel of a vehicle. Therein, a PV module shall be placed on top of such body panel or, preferably, the PV module shall be integrated into the body panel. Specifically, one or more solar cells may be arranged in an air tight and water tight manner in a recess provided in a carrier structure of a car body panel.

In an alternative approach for manufacturing PV modules, it has been proposed by the present applicant in another earlier patent application WO 2020/187792 A1 to integrate a solar cell arrangement into a moulded layer formed by injection moulding. Therein, the solar cell arrangement is interposed between polymeric foils, thereby forming a so-called photovoltaic label which may be securely handled and in which the solar cells are for example protected against excessive mechanical stress during an injection moulding procedure.

Another approach for a car body panel comprising an integrated solar cell arrangement has been proposed by the present applicant in earlier patent applications PCT/EP2021/083775 and GB 2019566.5 filed in the United Kingdom, having the title "Car body panel including a solar cell arrangement and method for producing same".

In each of these prior art approaches, the car body panel including the solar cell arrangement may be regarded as a photovoltaic module unit, the unit having a predefined shape and size. A body panel of a vehicle including an integrated PV module may be referred to herein as PV integrated car body panel.

Possible features and characteristics of such approaches of car body panels and approaches for fabricating a car body panel including a photovoltaic module have been described by the applicant in the above mentioned patent applications as well as in further prior patent applications such as two patent applications WO 2021/260024 A1 and WO 2021/260021 A1. Features and characteristics of such approaches may also apply to the PV (car body) panel and the production method described herein and the content of the earlier patent applications shall be incorporated in its entirety herein by reference.

### SUMMARY OF THE INVENTION AND OF EMBODIMENTS

As indicated above, prior PV panels are typically produced as a unit having a predefined shape and size. However, it has been found that, for particular applications, it may be beneficial to enable simply producing PV panels with adaptable, individual shapes and sizes. Particularly, it may be an object to provide a method for producing a PV panel, particularly a PV vehicle body panel, in which a solar cell arrangement is integrated and which fulfils both, high functional requirements as well as high aesthetic requirements while being adapted to a size or space available for PV integration at an individual vehicle. Furthermore, it may be an object to provide a production method which enables a relatively simple fabrication procedure, high fabrication yield and/or low fabrication costs while providing a fabrication result as a highly functional, reliable and aesthetic PV-integrated (vehicle body) panel. Furthermore, it may be an object to provide a PV panel, particularly a PV car body panel, being highly functional and reliable as well as aesthetic and furthermore being producible in a reliable and cost efficient manner.

Such objects may be met with the subject-matter of the independent claims. Advantageous embodiments are defined in the dependent claims and described in the following specification and visualised in the associated figures.

According to a first aspect of the present invention, a method for producing a photovoltaic panel, particularly a photovoltaic vehicle body panel, is proposed. The method comprises at least the following steps, preferably in the indicated order:
providing a sheet-like photovoltaic label wound into a roll configuration,
providing a support structure having a higher rigidity than the photovoltaic label,
unrolling a portion of the photovoltaic label from the roll configuration, and
fixing the unrolled portion of the photovoltaic label to the support structure.

Therein, the photovoltaic label comprises a front side polymeric stabilisation foil, a front side polymeric lamination foil, a rear side polymeric lamination foil and, optionally, a rear side polymeric stabilisation foil as well as a solar cell arrangement interposed between the front and rear side lamination foils. The solar cell arrangement comprises multiple solar cell strings. The photovoltaic label further comprises multiple electrically conductive switchback lines. The solar cell strings are arranged next to each other along a length direction of the photovoltaic label. Each solar cell string comprises multiple solar cells being arranged next to each other along a width direction of the photovoltaic label and being electrically interconnected with each other. Therein, for each of the solar cell strings, at least at a first side edge of the photovoltaic label, an electrical connection line being interconnected to a first end of the solar cell string is remotely accessible. Furthermore, for each of the solar cell strings, an associated one of the switchback lines extends from an area at or close to a second side edge of the photovoltaic label to the first side edge of the photovoltaic label and a portion of the switchback line is remotely accessible at the first side edge of the photovoltaic label.

According to a second aspect of the invention, a photovoltaic panel, particularly photovoltaic vehicle body panel, is proposed to comprise a sheet-like photovoltaic label and a support structure having a higher rigidity than the photovoltaic label. The photovoltaic label is fixed to the support structure. The photovoltaic label comprises a front side polymeric stabilisation foil, a front side polymeric lamination foil, a rear side polymeric lamination foil and, optionally, a rear side polymeric stabilisation foil as well as a solar cell arrangement interposed between the front and rear side lamination foils. The solar cell arrangement comprises multiple solar cell strings. The photovoltaic label further comprises multiple electrically conductive switchback lines. The solar cell strings are arranged next to each other along a length direction of the photovoltaic label. Each solar cell string comprises multiple solar cells being arranged next to each other along a width direction of the photovoltaic label and being electrically interconnected with each other. Therein, for each of the solar cell strings, at least at a first side edge of the photovoltaic label, an electrical connection line being interconnected to a first end of the solar cell string is remotely accessible. Furthermore, for each of the solar cell strings, an associated one of the switchback lines extends from an area at or close to a second side edge of the photovoltaic label to the first side edge of the photovoltaic label and a portion of the switchback line is remotely accessible at the first side edge of the photovoltaic label.

Briefly summarised and without limiting the scope of the invention, basic ideas underlying embodiments of the invention and associated possible advantages will be roughly described as follows:
As indicated above, conventional PV panels are generally produced as units of standardised sizes, i.e. each PV panel is produced in a production procedure with a same size. In contrast hereto, the approach described herein allows producing PV panels in a simple manner with the size, particularly the length, of an individual PV panel being adapted to the individual requirements of an individual application. This may be beneficial for example upon providing PV panels for applications in which a space available for the PV panel varies from application to application. Particularly, this approach may be beneficial for application fields in which PV panels are required which have generally a same width for various individual applications but different lengths in the various applications.

For example, it may be beneficial to include integrated photovoltaics into a lining for a cargo box of a vehicle such as a truck or a trailer. Such cargo box typically has a standardised width and height, but the length varies from vehicle to vehicle. Accordingly, upon preparing a PV panel forming a PV integrated vehicle body panel, the approach described herein allows easily adapting the length of the PV panel to the intended length of the cargo box.

Therein, as described in further detail below with regards to specific embodiments, the sheet-like PV label and the support structure may be fixed to each other. Specifically, the PV label and/or the support structure may be provided in a roll configuration such that they may be glued or laminated to each other for example in a roll-to-roll procedure and may then be cut to the intended length. As the intended length of the PV panel may vary from application to application, the solar cells included in the PV label are not completely electrically interconnected, i.e. wired, in the originally provided PV label. Instead, the PV label comprises several electrically independent solar cell strings, each string including multiple interconnected solar cells. Furthermore, the PV label comprises electrically conductive connection lines and switchback lines for each of the multiplicity of solar cell strings. These connection lines and switchback lines are arranged and adapted such that they are remotely accessible at at least one of opposite edges of the PV label. The connection lines and switchback lines may therefore be used to interconnect the multiple solar cell strings in an "a posteriori interconnection procedure". In other words, the solar cell strings in a PV label are not initially electrically interconnected with each other upon preparing the PV label itself, but may be interconnected in a later interconnection procedure, for example after fixing the PV label to the support structure and/or after cutting the PV label to the intended length. Accordingly, while the PV label is initially not adapted for providing a PV panel of an intended length with all its solar cell strings being already interconnected, the PV label may be configured to the intended length during producing the PV panel by electrically interconnecting its solar cell strings using the remotely accessible connections lines and/or switchback lines. As a result, PV panels of various sizes may be produced in a very simple, cost-effective and/or automatized manner.

In the following, possible features of embodiments of the invention and associated possible advantages will be described in more detail.

The approach proposed herein is particularly suitable for a PV-integrated (vehicle body) panel comprising multiple PV cells which are prepared based on brittle semiconductor wafers. The PV cells may be for example solar cells being fabricated based on crystalline silicon wafers. Such wafer-based Si-PV cells may generally have e.g. a high efficiency of more than 15% (i.e. e.g. between 17% and 26%) and a high reliability. Furthermore, well established industrial processes exist for their fabrication. Such PV cells typically have lateral dimensions of between 50x50 mm² and 300x300 mm², mostly between 150x150 mm² and 200x200 mm², with a square shape, a rectangular shape, a round shape, a semi-round shape or any other shape. Furthermore, such PV cells generally have a thickness of more than 50 µm, typically between 100 µm and 300 µm.

Having such thickness, the PV cells are relatively rigid, i.e. they may generally not be bent into small bending radii of e.g. less than their lateral dimensions. Generally, it may be assumed that, depending on a cell size, bending radii of less than 80 cm, less than 90 cm or less than 100 cm should be avoided.

Each PV cell comprises electric contacts. The electric contacts of neighbouring PV cells may be interconnected via electrical connections such that these PV cells may be electrically connected in series, in parallel or in any combination of series and parallel connections. The electrical connections may be provided by one or more electrically conducting ribbons and/or one or more copper solderings between two adjacent photovoltaic cells. A plurality of interconnected PV cells forms part of a solar cell arrangement, sometimes also referred to as solar cell string. Particularly in conventional approaches. The solar cell arrangement may further comprise additional components such as external contacts via which the solar cell arrangement may be connected to an external electric circuit, such external contacts sometimes being referred to as forming part of a junction box. Furthermore, the solar cell arrangement may comprise for example bypass diodes or other electric components. Additionally, one or more release loops for releasing mechanical tensions may be included in the solar cell arrangement.

The solar cell arrangement is generally comprised in an encapsulation into which the solar cells, the electrical interconnections and possibly other components are embedded. Typically, the encapsulation comprises or consists of a thermoplastic polymer such as EVA (Ethylene Vinyl Acetate) or POE (Polyolefin Elastomer). The encapsulation may be composed of a front side polymeric lamination foil and a rear side polymeric lamination foil enclosing the plurality of solar cells from opposite sides. The lamination foils may also be referred to as encapsulation foils. In a lamination procedure, such front and rear side encapsulation foils may then be heated beyond a glassifying temperature of the polymeric material while being pressed against each other. Accordingly, the sticky viscous or even partially molten polymer material of both encapsulation foils may combine in regions where the foils contact each other and/or may glue to solar cells interposed between the encapsulation foils. Accordingly, upon cooling down and solidifying the polymer material, the solar cells and the polymer material of the lamination foils may form an encapsulation.

As the solar cell arrangement in its encapsulation is generally very fragile, the solar cell arrangement including the solar cells, the electric connections and the encapsulation is reinforced by one or more stabilisation foils for forming a PV label. Preferably, a front side polymeric stabilisation foil and a rear side polymeric stabilisation foil may enclose the interposed solar cell arrangement and may form a substrate and a superstrate, respectively, prior to reinforcing the PV label by fixing it to the support structure. In specific embodiments, the PV label may not necessarily comprise the rear side polymeric stabilisation foil. The one or more polymeric stabilisation foils may have a thickness of typically between 250µm and 2500µm. Each of the foils may adjoin and/or cover a part or an entirety of one of opposing surfaces of all of the PV cells. The polymeric stabilisation foils may be made with various polymeric materials such as, polycarbonate (PC), polyethylenterephthalat (PET), polyamide (PA), polyetheretherketone (PEEK), Acrylonitrile butadiene styrene (ABS), Polymethyl methacrylate) (PMMA), Polyvinylchlorid (PVC) or a mix of them. At least the front side stabilisation foil as well as the front side lamination foil shall consist of an optically translucent or transparent material. Particularly, a material forming the stabilisation foil may be a thermoplastic material, i.e. a material which becomes plastic or viscous upon being heated to elevated temperatures. The front and rear side polymeric stabilisation foils may enclose the interposed solar cell arrangement and, upon being joined with each other, encapsulate the solar cell arrangement. Optionally, glass fiber reinforced or carbon fiber reinforced plastics may be included between the polymeric foils.

Particularly, the front side stabilisation polymeric foil, the rear side stabilisation polymeric foil and the PV cells may be joined together by an application of heat and/or a lamination process. In other words, after having arranged e.g. the rear side polymeric stabilisation foil, the solar cell arrangement with its encapsulation and finally the front side polymeric stabilisation foil on top of each other in a lose manner, these stacked layers may be interconnected by mechanically joining them with each other. Such joining may be induced for example by applying sufficient heat to the stack such that the polymeric material of the polymeric foils becomes viscous and/or sticky. Accordingly, upon such temporary application of heat, the polymeric stabilisation foils may mechanically interconnect with each other and/or with the interposed solar cell arrangement.

Thus, the front and rear side polymeric stabilisation foils and the solar cell arrangement are joined in a lamination procedure. The lamination procedure may be integral with the lamination procedure used for forming the encapsulation embedding the PV cells, i.e. both the front and rear side polymeric stabilisation foils as well as the front and rear side polymeric encapsulation foils may be glassified or partially molten within a single lamination step. Alternatively, two separate lamination steps may be performed, i.e., first, the solar cell arrangement is laminated with the encapsulation foils enclosing the PV cells and, then, the PV label is laminated with the stabilisation foils enclosing the solar cell arrangement in between. As a result of such lamination procedure, the front and rear side polymeric foils and, optionally, also the PV cells are integrally joined with each other in a positive substance jointing. However, the lamination procedure may alternatively or additionally include other measures for joining the polymeric foils such as for example applying a glue or adherent at an interface between the polymeric foils and/or at an interface between one of the polymeric foils and the solar cell arrangement.

The entire PV label may have a thickness in a range of between 0.5 mm to 10 mm, typically between 0.5 mm to 5 mm or between 1 mm and 3 mm. Lateral dimensions, i.e. a width, of the PV label may range from about 0.1 m to 5 m, typically from 0.3 m to 3 m. The PV label may be flexible and bendable and may be wound e.g. into a roll configuration in which the PV label is arranged in a cylindrical or quasi-cylindrical configuration. Therein, a bending radius may be adapted to a rigidity and/or bendability of the solar cells included in the PV label such as to reliably avoid any cell breakage. The solar cells comprised in the car body panel cover a substantial portion, i.e. for example more than 30%, preferably more than 50%, more than 70% or even more than 90%, of an entire area of the car body panel.

The PV label is generally flexible, bendable and/or, at least in some applications, not sufficiently self-supporting. Accordingly, for forming a self-supporting PV panel, the PV label generally has to be reinforced by a support structure. Such support structure typically has a higher mechanical rigidity and/or stability than the PV label. Such higher mechanical stability may result, inter-alia, from larger geometrical dimensions such as a larger thickness compared to the thickness of the PV label and/or higher stiffness due to material properties of the material forming the support structure. The support structure and the PV label are generally mechanically interconnected such that forces acting onto the PV label may be transmitted to the support structure and vice versa.

According to the approach described herein, upon preparing the PV label, not all of the solar cells comprised therein are ready electrically connected with each other such as to form an entirely interconnected solar cell arrangement. To the contrary, only the solar cells included in individual solar cell strings are electrically connected with each other, whereas solar cells of different solar cell strings are not electrically connected in the initially produced PV label. Instead, the PV label is pre-configured for electrically interconnecting its solar cell strings in a later interconnection procedure.

For such purpose, the solar cells comprised in a solar cell string are arranged next to each other along the width direction of the PV label. In other words, the solar cells of a solar cell string may be arranged one next to the other along a line extending from close to a first side edge to close to a second side edge of the PV label. Preferably, the solar cells of a string are arranged along a straight line extending in the width direction. The solar cells of such solar cell string are electrically interconnected with each other using for example conductive strips, band connectors, cables or the like. Particularly, the solar cells of such string may be connected in series. Alternatively, only some of the solar cells of the string may be connected in series whereas another group of solar cells of the same string is connected in parallel hereto.

In order to enable electrically interconnecting neighbouring solar cell strings, each string comprises an electrical connection line which is electrically connected to a first end of the solar cell string and which is remotely accessible at the first side edge of the PV label. In other words, such accessible electrical connection line is not fully enclosed and/or laminated within the lamination foils and/or stabilisation foils of the PV label. Instead, at least a small area of such connection line is locally exposed such as to be such that an electric contact may be made to the connection line from external of the PV label. Optionally, the remotely accessible area of the connection line laterally protrudes from the respective lateral edge of the PV label. The connection line may be a connector e.g. of a same type as used for interconnecting the solar cells in a string. Alternatively, the connection line may be formed with a separate cable, conductor strip or the like.

Furthermore, for each of the solar cell strings, there is an associated electrically conductive line which is referred to herein as switchback line. Such switchback line shall extend from at or close to the second side edge of the PV label to the opposite first side edge of the PV label. In other words, the switchback line generally extends along the width direction of the PV label from one lateral side edge to the opposite lateral side edge. The switchback lines may be part of the solar cell arrangement and may also be interposed between the front and rear side lamination foils or between any other pair of polymeric foils comprised in the PV label.

Therein, at least at the first side edge of the PV label, the switchback line comprises a portion which is remotely accessible, i.e. which is exposed in a similar way as the remotely accessible portion of the connection line connected to the associated solar cell string. At the second end, the switchback line may be connected to the solar cell string or, alternatively, the switchback line may be non-connected to the solar cell string but may comprise a further portion being remotely accessible. The switchback line may be a connector e.g. of a same type as used for interconnecting the solar cells in a string. Alternatively, the switchback line may be formed with a separate cable, conductor strip or the like.

As described in further detail below, the remotely accessible portion of the connection lines to the solar cell strings and the remotely accessible portion of the switchback lines may be used to electrically interconnect all solar cell strings comprised in the PV label in an a-posteriori interconnection procedure.

According to an embodiment, the production method further comprises cutting the photovoltaic label and the support structure along the width direction at a position being located with regards to the length direction between adjacent ones of the solar cell strings, thereby providing the photovoltaic panel with an intended length.

In other words, upon unrolling or after having enrolled the PV label from its initially wound roll configuration, the PV label may be cut into an intended length. For example, during producing a PV panel, the PV label may successively and/or continuously be unrolled and be arranged along the support structure. Upon having reached the intended length of the PV panel, the PV label may be cut in its width direction. Preferably, such cutting action includes also cutting the support structure to the intended length. The cutting action may be established with any kind of cutting tool such as a saw, a knife, a blade, a scissor, a laser beam cutter, a water beam cutter or the like.

The cutting action is established at a position which, with regards to the length direction of the PV panel, is located between neighbouring solar cell strings, such that none of such strings is damaged upon cutting the PV label. Preferably, the solar cells of the strings are arranged such that a gap of for example more than 1 mm, preferably more than 5 mm, remains between neighbouring solar cell strings. Accordingly, the cutting action may be established along such gap. By cutting the PV label between neighbouring solar cell strings, its length may be individually set to an intended length of the PV panel, with an accuracy of typically only a few centimetres. Therein, the length adaption accuracy corresponds roughly to a pitch of the arrangement of solar cell strings within the PV label. Such pitch generally corresponds to a distance between neighbouring solar cell strings in the length direction of the PV label.

According to an embodiment, for each of the solar cell strings, at a second side edge opposite to the first side edge of the photovoltaic label, an electrical connection line being interconnected to a second end of the solar cell string is remotely accessible. Furthermore, for each of the solar cell strings, a portion of the switchback line associated to the solar cell string is remotely accessible at the second side edge of the photovoltaic label.

Expressed differently, both, the solar cell strings as well as the associated switchback lines may be remotely electrically accessible not only at the first side edge but also at the second side edge of the PV label. Accordingly, the remotely accessible connection lines of the solar cell strings as well as the remotely accessible switchback lines may be electrically interconnected at both opposing side edges in order to thereby establish an intended overall circuitry including the solar cell strings of the entire PV panel.

Particularly, according to an embodiment, the method further comprises electrically interconnecting the multiple solar cell strings by electrical interconnections electrically connecting at least one of the remotely accessible connection lines connected to one of the solar cell strings at one of its side edges to
(i) the remotely accessible connection line connected to another one of the solar cell strings at the respective same side edge and/or to
(ii) the remotely accessible portion at the respective same side edge of the switchback line associated to at least one of the same solar cell string and another one of the solar cell strings.

Accordingly, the various solar cell strings and/or the various associated switchback lines may be electrically interconnected with each other by electrically connecting their remotely accessible portions at one or both of the side edges of the PV label. Therein, depending on the specific configuration of such connection, the solar cell strings may be electrically connected in series, in parallel or in a combination thereof. For example, electrical interconnectors such as cables or the like may be provided with a first end electrically connected to a first exposed portion of e.g. a connection line of a solar cell string and with an opposing second end connected to a second exposed portion of e.g. a connection line of another solar cell string or of a switchback line associated to the same or a neighbouring solar cell string. The interconnection procedure may be executed at any point in time during the production procedure, as the PV label has already been pre-configured for such a-posteriori interconnection procedure by providing the remotely accessible portions of the connection lines and switchback lines.

For example, according to an embodiment, the multiple solar cell strings are electrically interconnected after unrolling the portion of the photovoltaic label from the roll configuration.

By first unrolling the portion of the PV label from its wound roll configuration to for example a plannar configuration and, subsequently, interconnecting the solar cell strings at the side edges of the PV label, the interconnection procedure may be significantly simplified. For example, the interconnection procedure may be established with a tool which is successively or continuously displaced linearly along the stretched-out PV label. Preferably, the interconnection procedure is established after or simultaneously with the PV label being fixed to the support structure.

According to an embodiment, the unrolled portion of the photovoltaic label is fixed to the support structure in a continuous roll-to-roll procedure.

Roll-to-roll fabrication procedures are commonly used for combining two or more flexible sheet-like members. Therein, one or more sheet-like members are originally provided in a wound roll configuration. For combining the members, one or more of the members are successively unrolled before being arranged along each other. In such roll-to-roll procedure, the sheet-like members may then be brought into contact with their surfaces or even be pressed against each other to form a common, preferably sheet-like overall structure.

In the method proposed herein, the originally wound PV label may be unrolled from its roll configuration and may be arranged adjacent to and preferably contacting to a surface of the support structure. The support structure may also be originally wound in a roll configuration and may be unrolled therefrom simultaneously with unrolling the PV label.

According to an embodiment, the unrolled portion of the photovoltaic label is fixed to the support structure using a gluing procedure or a laminating procedure.

In such gluing procedure or laminating procedure, a positive substance jointing may be established between the PV label and the support structure. Preferably, both components are glued or laminated to each other along their entire contact interface area. Thereby, a very reliable fixation may be established between the PV label and the support structure.

According to an embodiment, upon producing the PV panel, the roll configuration of the PV label is provided wound into the roll configuration with a minimum diameter of at least 0.5 m, preferably at least 0.8 m, at least 0.9 m or at least 1m.

It has been observed that solar cells, particularly wafer-based solar cells, included in a PV label should not be excessively bent in order to avoid cell breakage. However, while it is known that e.g. silicon wafers are very brittle, it has been observed that even wafer-based solar cells may be bent to a certain extend upon being sufficiently supported by an enclosing structure. For example, it has been observed that, in a PV label where the solar cells are encapsulated and supported by one or more stabilisation foils, the entire PV label including its solar cells may be bent to a certain extent. Specifically, depending on characteristics of the solar cells such as their thickness and/or their lateral dimensions, a PV panel may generally be bent into a roll configuration with a diameter of 1 m or less without risking cell breakage. This observation may be used in the proposed production method for providing the PV label in a roll configuration, thereby enabling advantageous roll-to-roll manufacturing techniques to be used for fast, simple, automatized and/or cost-effective PV panel production. In order to reduce space consumption, the diameter of the roll configuration should generally be smaller than 5 m, preferably smaller than 2 m and most preferably be between 0.8 m and 1.2 m.

In the finally produced PV panel, according to an embodiment, the electrical interconnections connecting multiple solar cell strings of the PV label extend along at least one of the side edges of the photovoltaic label.

In other words, while, in conventional PV panels, all electrical connections used for interconnecting the solar cells are typically included inside the encapsulation enclosing the solar cell arrangement, the PV panel proposed herein generally comprises electrical connections which are outside such encapsulation and which extend along side edges of the PV label. As described further above, such external electrical connections may be established in an a-posteriori interconnection procedure, thereby enabling individually adapting the length of the PV label and its circuitry to an intended length of the PV panel.

According to an embodiment, the PV panel further comprises a frame extending along the side edges. The electrical interconnections may then be accommodated within the frame.

The frame may serve for various functionalities. For example, the frame may mechanically stabilise the entire PV panel. Particularly, the frame may stabilise side edges of the PV panel. Alternatively or additionally, the frame may be used for mechanically fixing the PV panel to another PV panel, to a rack, to a mount or to any other component. The frame may have a geometry such as to enclose, hold, clamp and/or press the PV panel along its side edges. For example, the frame may be provided with an elongate profile which may be arranged along a side edge of the PV panel and which may be attached to at least one or preferably both of opposing surfaces of the PV panel close to the side edge. Optionally, the frame may have a cross-section being open at one side, such as a U-shaped, V-shaped or W-shaped cross-section.

Having such frame, the electrical connections at the side edge of the PV panel may be accommodated within such frame. In other words, the frame may cover and thereby protect the electrical connections at the side edge of the PV panel.

Optionally, the frame may even be pre-configured to include the electrical connections such that, upon fixing the frame to the side edge of the PV panel, the electrical connections are simultaneously connected to the remotely accessible portions of the electrical connection lines and/or switchback lines of the PV panel. For such purpose, the frame may for example consist of or comprise electrically isolating material into which electrically conductive connectors are integrated at suitable positions for forming the required electrical connections. Such pre-configured frame may then be correctly aligned with the PV label and the support structure upon preparing the PV panel in order to thereby automatically establish the a-posteriori interconnection procedure.

According to an embodiment, the support structure has a sheet-like geometry and has a thickness larger than a thickness of the photovoltaic label.

In other words, while the PV label generally has a relatively small thickness of typically less than 1 cm, in many cases less than 4 mm, and is therefore hardly mechanically loadable and/or self-supporting, the support structure may have a significantly higher mechanical loadability compared to the PV label, such loadability possibly resulting at least in part from a higher thickness of the support structure. For example, the support structure may have a thickness of more than 0.5 cm, preferably more than 1cm or even more than 1.5 cm.

Nevertheless, the sheet-like support structure may be bendable such as to be arranged in a roll configuration having a diameter of e.g less than 5 m, preferably less than 2 m or even less than 1 m. Accordingly, similar to the PV label, the support structure may be processed in a roll-to-roll procedure.

According to an embodiment, the support structure has a sheet-like geometry with a honeycomb structure.

A honeycomb structure may have a geometry of a honeycomb to allow a minimization of an amount of used material to reach minimal weight and/or minimal material cost. The geometry of honeycomb structures can vary widely but the common feature of all such structures is an array of hollow cells formed between thin vertical walls. Such array may be arranged in a repetitive pattern. The cells are often columnar and/or hexagonal in shape. A honeycomb shaped structure provides a material sheet with minimal density and relative high out-of-plane compression properties and out-of-plane shear properties. Honeycomb structures are commonly made by layering a honeycomb material between two thin layers that provide strength in tension. This forms a plate-like assembly.

In the PV panel described herein, the PV label may be fixed to and/or may form part of the honeycomb structure at its one surface, whereas, optionally, another sheet-like backsheet may be fixed at an opposite surface of the honeycomb structure. Overall, the entire PV label supported by the honeycomb structure obtains a very high mechanical loadability at low weight.

The honeycomb structure may be made with various materials such as polymeric material, metal materials, other materials or combinations thereof. The honeycomb structure and/or the optional rear side polymeric stabilisation foil of the PV label and/or the optional backsheet may be reinforced with fibres such as glass fibres, carbon fibres, etc. to increase the mechanical loadability.

According to an embodiment, each of the switchback lines is arranged behind the associated solar cell string.

In other words, while the switchback lines should generally be included in the PV label and may be encapsulated in its polymeric foils, the switchback lines may be arranged such that they are not arranged laterally next to an associated solar cell string but behind such solar cell string. Accordingly, no partial area of the PV label is to be reserved for accommodating the switchback lines but, instead, the switchback lines are accommodated in the PV label at a rear side of the solar cell strings. Accordingly, a surface area to be covered by the solar cells may be maximised in the PV label.

It shall be noted that possible features and advantages of embodiments of the invention are described herein partly with respect to a method of producing a PV panel and partly with respect to a PV panel producible with such method. One skilled in the art will recognize that the features may be suitably transferred from one embodiment to another and features may be modified, adapted, combined and/or replaced, etc. in order to come to further embodiments of the invention.

### BRIEF DESCRIPTION OF THE DRAWINGS

In the following, advantageous embodiments of the invention will be described with reference to the enclosed drawings. However, neither the drawings nor the description shall be interpreted as limiting the invention.
Fig. 1 shows a side view of an arrangement used for producing a photovoltaic panel in accordance with an embodiment of the present invention.
Fig. 2 shows a top view of a portion of a photovoltaic panel in accordance with an embodiment of the present invention.

The figures are only schematic and not to scale. Same reference signs refer to same or similar features.

### DESCRIPTION OF PREFERRED EMBODIMENTS

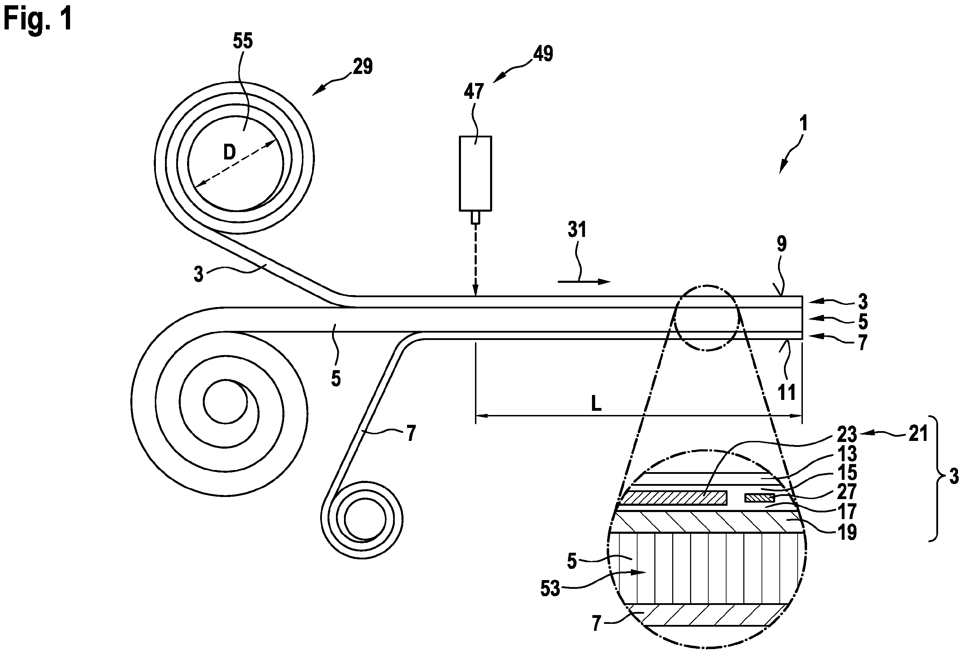

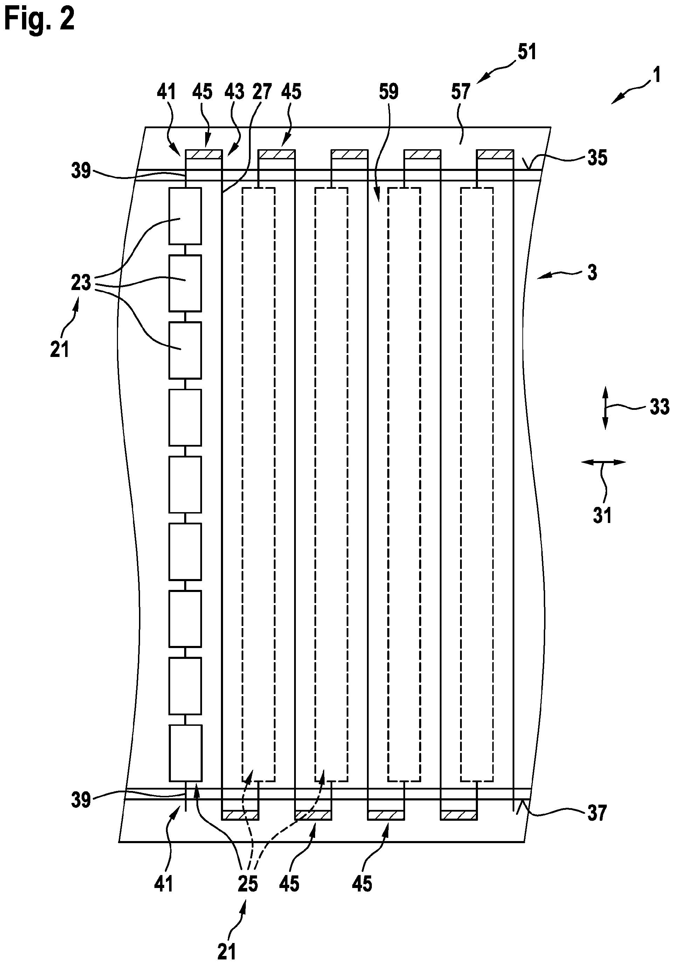

Fig. 1 shows an arrangement with which a photovoltaic panel 1 may be produced. Fig. 2 shows a top view onto a portion of such PV panel 1. The PV panel 1 may be specifically adapted such as to serve as a PV vehicle body panel. For example, the PV panel 1 may be provided such as to form a lining of a cargo box for a truck or a trailer.

For producing the PV panel 1, a sheet-like PV label 3 at a front surface 9 is to be combined with a support structure 5 and, optionally, a backsheet 7 at a rear surface 11 of the PV panel 1. The technique of combining these components may be accomplished using a roll-to-roll procedure. Thereby, the layers formed by the PV label 3, the support structure 5 and the backsheet 7 may be glued or laminated to each other in a highly automatised and/or high-throughput process.

For such purpose, the PV label 3 is provided in a roll configuration 29 in which the bendable PV label 3 is wound onto a barrel 55. Similarly, the support structure 5 and the backsheet 7 are also provided in a roll configuration. For producing the PV panel 1, the PV label 3, the support structure 5 and the backsheet 7 are successively unrolled from the roll configuration to an unrolled, preferably planar configuration, in which all three layers are stacked on top of each other and pressed into mechanical contact with each other. Thereby, a common layer stack may be generated by gluing or laminating the various layers along their contact interfaces. Such layer stack has a significantly higher mechanical loadability than the PV label 3 alone. Particularly, the support structure 5 generally has a higher rigidity than the PV label 3, possibly resulting, inter alia, from the support structure 5 having a higher thickness than the PV label 3. Furthermore, the support layer 5 may have a structure such as a honeycomb structure 53 for further enhancing the mechanical loadability of the entire layer stack of the PV label 3.

As visualised in the zoomed representation in Fig. 1, the PV label 3 comprises a front side polymeric stabilisation foil 13, a front side polymeric lamination foil 15, a rear side polymeric lamination foil 17 and a rear side polymeric stabilisation foil 19. Furthermore, a solar cell arrangement 21 including multiple solar cells 23 is interposed between the front and rear side lamination foils 15, 17. Additionally, also multiple switchback lines 27 are interposed between the front and the rear side lamination foils 15, 17. At least the front side lamination and stabilisation foils 15, 13 are transparent. The front and rear side stabilisation foils 13, 19 generally have a larger thickness than the lamination foils 15, 17. The solar cell arrangement 21 comprises multiple wafer-based silicon solar cells 23 which are electrically interconnected to form multiple solar cell strings 25.

While such wafer-based solar cells 23 are generally very brittle, they are supported by the stack of polymeric foils 13, 15, 17, 19. Due to such support, the entire PV label 3 may be bent and may therefore be wound onto the barrel 55 in the roll configuration 29 such that there is no significant risk of solar cell breakage as long as the PV label 1 is not bent beyond an excessive bending curvature having a diameter lower than an allowable minimum diameter D. Depending on characteristics of the solar cells such as their material, their lateral dimensions, their thickness and/or their crystal structure, such minimum diameter may be typically between 0.5 m and 1 m and corresponds to a minimum allowable diameter of the barrel 55.

As visualised in Fig. 2, the solar cell arrangement 21 comprises multiple solar cell strings 25, each solar cell string comprising multiple solar cells 23. In each solar cell string 25, the solar cells 23 are arranged next to each other along a width direction 33 of the PV label 1 and the solar cells 23 are electrically interconnected with each other. The multiple solar cell strings 25 are arranged next to each other along a length direction 31 of the PV label 3. Between neighbouring solar cell strings 25, there is a small gap 59 having a width of e.g. a few millimetres.

It is to be noted that, in Fig. 2, the solar cell strings 25 and the electrical interconnections between their solar cells 23 are only visualised schematically and that, for sake of simplified visualisation, individual solar cells 23 are only represented for the leftmost solar cell string 25.

Accordingly, the solar cell strings 25 are arranged such as to extend from a first side edge 35 of the PV label 3 to a second side edge 37 of the PV label 3. While all of the solar cells 23 of an individual solar cell string 25 are electrically interconnected with each other in the PV label 3, there is initially no electrical interconnection between solar cells 23 comprised in different solar cell strings 25. Instead, each of the solar cell strings 25 comprises an electrical connection line 39 which is interconnected to a first end of the solar cell string 25. At least a portion 41 of such connection line 39 is remotely accessible, i.e. may be electrically contacted from outside the PV label 3. For example, the remotely accessible portion 41 of the connection line 39 may laterally protrude beyond the first side edge 35 of the PV label 3 and may be exposed therefrom.

In the example shown in Fig. 2, the solar cell strings 25 comprise electrical connection lines 39 at both ends such that one remotely accessible portion 41 of a respective one of the connection lines 39 is exposed at each of the first and second side edges 35, 37.

Furthermore, the PV label 3 comprises multiple switchback lines 27. Preferably, one switchback line 27 is associated to each one of the solar cell strings 25. The switchback line 27 extends from an area at or close to the second side edge 37 to the first side edge 35 of the PV label 3. A portion 43 of the switchback line 27 is remotely accessible at the first side edge 35.

In the example shown in Fig. 2, the switchback line 27 comprises portions 43 being remotely accessible at both, the first side edge 35 and the second side edge 37. However, in an alternative approach (not shown), instead of having a remotely accessible portion 43 at the second side edge 37, the switchback line 27 may also be directly electrically connected to the second end of the associated solar cell string 25, for example via an electrical connection integrally included in the PV label 3.

For producing the PV panel 1, the PV label 3, the support structure 5 and the backsheet 7 are successively unrolled from their roll configuration 29 and are then attached to each other to form a layer stack unit.

Upon having achieved a length corresponding to an intended length 1 of the PV panel 1 to be produced, the entire layer stack unit is cut along its width direction 33 using a cutting tool 49 such as for example a laser cutter 47. Therein, the cut is set such as to be located between adjacent ones of the solar cell strings 25, i.e. within the gap 59 between neighbouring solar cell strings 25.

Subsequently, i.e. in an a-posteriori interconnecting procedure, the multiple solar cell strings 25 are electrically interconnected by applying electrical interconnections 45 connecting the remotely accessible portions 41 of the connection lines 39 connected to one of the solar cell strings 25 at one of the side edges 35, 37 to a remotely accessible portion 43 of an adjacent switchback line 27 associated to the same solar cell string 25 or to another solar cell string 25. Thereby, an electrical series connection may be established between neighbouring solar cell strings 25.

In an alternative approach, alternative or additionally to establishing such series interconnection, neighbouring solar cell strings 25 may be interconnected in parallel by providing electrical interconnections 45 connecting remotely accessible portions 41 of connection lines 39 connected to each of the neighbouring solar cell strings 25 (such approach not being shown in Fig. 2). In principle, also a mixture of serial and parallel interconnections may be established in the a-posteriori interconnecting procedure.

As a result of such a-posteriori interconnecting procedure, all of the solar cell strings 25 in the PV panel 1 are electrically interconnected in a desired manner. Therein, the electrical interconnections 45 generally extend along at least portions of one of the side edges 35, 37 of the PV label 3.

Particularly, the PV panel 1 may comprise a frame 51. The frame 51 or portions thereof may extend along the side edges 35, 37 of the PV label 3 and may thereby mechanically reinforce the entire PV panel 1. Such frame 51 may be formed by elongate straight frame profiles 57 having for example a U-shaped cross-section. The electrical interconnections 45 may then be included in, incorporated in and/or covered by the frame 51. Accordingly, for example a cabling used for implementing the electrical interconnections 45 may be "hidden" in the frame 51.

It may be noted that, for sake of simple visualisation, the switchback lines 27 are shown in Fig. 2 to extend next to the solar cell strings 25, i.e. between neighbouring solar cell strings 25. However, for an actual implementation of the PV panel 1, it may be preferable to arrange the switchback lines 27 behind the solar cell strings 25 such that no additional area is to be reserved in the PV panel 1 for accommodating the switchback lines 27. In other words, by "hiding" the switchback lines 27 behind the solar cell strings 25, a maximum portion of the area of the PV panel 1 may be covered with solar cells 23.

Finally, it should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims.

### LIST OF REFERENCE SIGNS

- 1: PV panel
- 3: PV label
- 5: support structure
- 7: backsheet
- 9: front surface of PV panel
- 11: rear surface of PV panel
- 13: front side polymeric stabilisation foil
- 15: front side polymeric lamination foil
- 17: rear side polymeric lamination foil
- 19: rear side polymeric stabilisation foil
- 21: solar cell arrangement
- 23: solar cell
- 25: solar cell string
- 27: switchback line
- 29: roll configuration
- 31: length direction
- 33: width direction
- 35: first side edge
- 37: second side edge
- 39: connection line
- 41: remotely accessible portion of connection line
- 43: remotely accessible portion of switchback line
- 45: electrical interconnections
- 47: cutting tool
- 49: laser cutter
- 51: frame
- 53: honeycomb structure
- 55: barrel
- 57: frame profile
- 59: gap

## Claims

1. Method for producing a photovoltaic panel (1), particularly a photovoltaic vehicle body panel, the method comprising:
providing a sheet-like photovoltaic label (3) wound into a roll configuration (29),
providing a support structure (5) having a higher rigidity than the photovoltaic label, unrolling a portion of the photovoltaic label from the roll configuration, and
fixing the unrolled portion of the photovoltaic label to the support structure,
wherein the photovoltaic label comprises a front side polymeric stabilisation foil (13), a front side polymeric lamination foil (15), a rear side polymeric lamination foil (17) and, optionally, a rear side polymeric stabilisation foil (19) as well as a solar cell arrangement (21) interposed between the front and rear side lamination foils,
wherein the solar cell arrangement comprises multiple solar cell strings (25),
wherein the photovoltaic label further comprises multiple electrically conductive switchback lines (27),
wherein the solar cell strings are arranged next to each other along a length direction (31) of the photovoltaic label,
wherein each solar cell string comprises multiple solar cells (23) being arranged next to each other along a width direction (33) of the photovoltaic label and being electrically interconnected with each other,
wherein, for each of the solar cell strings, at least at a first side edge (35) of the photovoltaic label, an electrical connection line (39) being interconnected to a first end of the solar cell string is remotely accessible,
wherein, for each of the solar cell strings, an associated one of the switchback lines extends from an area at or close to a second side edge (37) of the photovoltaic label to the first side edge of the photovoltaic label and a portion of the switchback line is remotely accessible at the first side edge of the photovoltaic label.

2. Method according to claim 1, further comprising:
cutting the photovoltaic label and the support structure along the width direction at a position being located with regards to the length direction between adjacent ones of the solar cell strings, thereby providing the photovoltaic panel with an intended length (1).

3. Method according to one of the preceding claims,
wherein, for each of the solar cell strings, at a second side edge opposite to the first side edge of the photovoltaic label, an electrical connection line being interconnected to a second end of the solar cell string is remotely accessible,
wherein, for each of the solar cell strings, a portion of the switchback line associated to the solar cell string is remotely accessible at the second side edge of the photovoltaic label.

4. Method according to one of the preceding claims, further comprising:
electrically interconnecting the multiple solar cell strings by electrically connecting at least one of the remotely accessible connection lines connected to one of the solar cell strings at one of its side edges to at least one of
the remotely accessible connection line connected to another one of the solar cell strings at the respective same side edge and
the remotely accessible portion at the respective same side edge of the switchback line associated to at least one of the same solar cell string and another one of the solar cell strings.

5. Method according to one of the preceding claims,
wherein the multiple solar cell strings are electrically interconnected after unrolling the portion of the photovoltaic label from the roll configuration.

6. Method according to one of the preceding claims,
wherein the unrolled portion of the photovoltaic label is fixed to the support structure in a continuous roll-to-roll procedure and/or
wherein the unrolled portion of the photovoltaic label is fixed to the support structure using one of a gluing procedure and a laminating procedure.

7. Method according to one of the preceding claims,
wherein the roll configuration is provided wound into the roll configuration with a minimum diameter (D) of at least 0.5m.

8. Photovoltaic panel (1), particularly photovoltaic vehicle body panel, comprising:
a sheet-like photovoltaic label (3),
a support structure (5) having a higher rigidity than the photovoltaic label,
wherein the photovoltaic label is fixed to the support structure,
wherein the photovoltaic label comprises a front side polymeric stabilisation foil (13), a front side polymeric lamination foil (15), a rear side polymeric lamination foil (17) and, optionally, a rear side polymeric stabilisation foil (19) as well as a solar cell arrangement (21) interposed between the front and rear side lamination foils,
wherein the solar cell arrangement comprises multiple solar cell strings (25), and
wherein the photovoltaic label further comprises multiple electrically conductive switchback lines (27),
wherein the solar cell strings are arranged next to each other along a length direction (31) of the photovoltaic label,
wherein each solar cell string comprises multiple solar cells (23) being arranged next to each other along a width direction (33) of the photovoltaic label and being electrically interconnected with each other,
wherein, for each of the solar cell strings, at least at a first side edge (3 5) of the photovoltaic label, an electrical connection line (39) being interconnected to a first end of the solar cell string is remotely accessible,
wherein, for each of the solar cell strings, an associated one of the switchback lines extends from an area at or close to a second side edge of the photovoltaic label to the first side edge of the photovoltaic label and a portion of the switchback line is remotely accessible at the first side edge of the photovoltaic label.

9. Photovoltaic panel (1) according to claim 8,
wherein, for each of the solar cell strings, at a second side edge opposite to the first side edge of the photovoltaic label, an electrical connection line being interconnected to a second end of the solar cell string is remotely accessible,
wherein, for each of the solar cell strings, a portion of the switchback line associated to the solar cell string is remotely accessible at the second side edge of the photovoltaic label.

10. Photovoltaic panel (1) according to one of claims 8 and 9,
wherein the multiple solar cell strings are electrically interconnected by electrical interconnections (45) connecting the remotely accessible connection line connected to one of the solar cell strings at one of its side edges to at least one of the remotely accessible connection line connected to another one of the solar cell strings at the respective same side edge and
the remotely accessible portion at the respective same side edge of the switchback line associated to at least one of the same solar cell string and another one of the solar cell strings.

11. Photovoltaic panel (1) according to claim 10,
wherein the electrical interconnections extend along at least one of the side edges of the photovoltaic label.

12. Photovoltaic panel (1) according to one of claims 10 to 11,
further comprising a frame (51) extending along the side edges,
wherein the electrical interconnections are accommodated within the frame.

13. Photovoltaic panel (1) according to one of claims 8 to 12,
wherein the solar cells comprised in the solar cell strings are wafer-based silicon solar cells.

14. Photovoltaic panel (1) according to one of claims 8 to 13,
wherein the support structure has a sheet-like geometry and has a thickness larger than a thickness of the photovoltaic label and/or
wherein the support structure has a sheet-like geometry with a honeycomb structure (53).

15. Photovoltaic panel (1) according to one of claims 8 to 14,
wherein each of the switchback lines is arranged behind the associated solar cell string.
